# EUROPEAN PATENT SPECIFICATION

(11) **EP 1 391 869 B1**
(45) Date of publication and mention of the grant of the patent: **09.10.2013**
(21) Application number: 03090263.9
(22) Date of filing: 21.08.2003
(51) Int. Cl.: G09G 3/32, G09G 3/22

(54) **Circuit for driving matrix display panel with photoluminescence quenching devices and matrix display apparatus incorporating the circuit**
Schaltkreis zur Ansteuerung einer Matrixanzeigetafel mit Photolumineszenzlöschelementen und diesen Schaltkreis enthaltende Matrixanzeigevorrichtung
Circuit de commande d'un panneau d'affichage matriciel avec des éléments d'extinction de photoluminescence et dispositif d'affichage matriciel comportant ce circuit

(30) Priority: 23.08.2002 EP 02090299
(43) Date of publication of application: 25.02.2004
(73) Proprietor: Samsung Display Co., Ltd., Yongin-City, Gyeonggi-Do, 446-711 (KR)
(72) Inventor: Fischer, Joerg, 13053 Berlin (DE); Redecker, Michael, Dr., 12524 Berlin (DE)
(74) Representative: Hengelhaupt, Jürgen

(56) References cited:
- EP-A- 1 197 943
- GB-A- 2 379 317
- US-A- 5 990 629
- US-A1- 2001 055 828
- US-A1- 2002 027 537
- US-B1- 6 380 689
- DE JONG M J M ET AL: "Theory of luminescence quenching and photobleaching in conjugated polymers" PHILIPS JOURNAL OF RESEARCH, ELSEVIER, AMSTERDAM, NL, vol. 51, no. 4, 1998, pages 495-510, XP004142739 ISSN: 0165-5817
- FUJII A ET AL: "Photoluminescence quenching under reverse bias in organic multilayer structure utilizing 8-hydroxyquinoline aluminum" JPN J APPL PHYS, vol. 33, no. 3A, 1 March 1994 (1994-03-01), pages L348-L350, XP002292040

## Description

The present invention relates to a circuit for driving a photoluminescence quenching device (PQD) and a matrix display apparatus incorporating the circuit, and a plurality of PQDs. More particularly, the invention relates to a circuit for driving a matrix display panel including PQDs as pixels, which are defined by crossings of scan lines and data lines, and a matrix display apparatus incorporating the circuit.

### Description of the Related Art

Flat panel displays using organic light-emitting diodes (OLEDs) provide high brightness and a wide viewing angle. Using the self-emissive mode, OLEDs do not require any back light and are thus very effective under conditions of low to medium ambient light. However, with high ambient light, such as direct sunlight, a disproportionately large amount of power must be supplied to OLEDs to obtain required brightness. Moreover, high current is required in order to activate the elements having a light emitting structure. For this reason, reflective and re-emissive technologies, applied to liquid crystal displays (LCDs), are very effective for LCDs in a variety of ambient light conditions. However, when using these technologies, back light is required under conditions with low ambient light, which results in an increase in the dimensions of displays and increased power consumption.

The structure of OLEDs that can be operated both in emissive and re-emissive modes is disclosed in U.S. Published Patent Application 2002 0027537A1 and in European Patent A-1 197 943. A PQD has a structure similar to that of an OLED and can be operated in an emissive mode without back light and a re-emissive mode.

Furthermore, US Published Patent Application 2001/055828 discloses an active matrix display device alternating ON and OFF states of the OLEDs during normal operation of the display device in order to avoid blurred edges of motion pictures.

Driver circuits activating OLEDs are known from US Patent Nos. 6,157,356, 5,952,789, and 6,518,700. All of these driver circuits have a disadvantage in that they can realize only the emissive mode of operation of an OLED. Under conditions with high ambient light, a high current is required to activate the OLED elements in the emissive mode. This high current requirement leads to an increased fabrication cost.

### SUMMARY OF THE INVENTION

The invention is set fourth in claim 1. The present invention provides a circuit for driving a matrix display panel in which photoluminescence quenching devices (PQDs) can be operated in both an emissive mode and a re-emissive mode, thereby providing satisfactory brightness with a low current under conditions with high ambient light, so that power consumption and fabrication cost of the display panel and a matrix display apparatus using the circuit can be reduced.

According to an aspect of the present invention, there is provided a circuit for driving a PQD in a matrix display panel using PQDs, each PQD being a pixel at a crossing point of a scan line and a data line. The circuit for driving a PQD includes an activation transistor and a driver transistor. The activation transistor may be turned on according to a potential of the scan line connected to the circuit and, when turned on, outputs a potential of the data line connected to the circuit. The driver transistor is connected between a reference voltage terminal and a PQD driven by the circuit. When the activation transistor is turned on, a potential applied to the reference voltage terminal is applied to an anode of the PQD according to the potential of the data line. In an emissive mode, when the driver transistor is turned on, a forward voltage is applied between an anode and cathode of the PQD so that the PQD emits light. In a re-emissive mode, when the driver transistor is turned off, no voltage is applied between the anode and cathode of the PQD so that the PQD produces light by photoluminescence.

Using to the circuit of the present invention, a PQD can be operated in the emissive mode and re-emissive mode, depending on the operation of corresponding activation and driver transistors of the circuit. In other words, each PQD in a matrix display driven by a corresponding driving circuit can be operated in the emissive mode under conditions of low ambient light and in the re-emissive mode under conditions of high ambient light. Accordingly, satisfactory brightness can be produced under conditions with high ambient light and low current so that the power consumption and fabrication cost of a display can be reduced.

According to an aspect of the present invention, there is provided a matrix display apparatus including a matrix display panel and a plurality of driving circuits. The matrix display panel includes PQDs, each of which is a pixel at a crossing of a scan line and a data line. Each driving circuit applies a forward voltage between an anode and a cathode of a corresponding PQD according to a gray scale value in an emissive mode, and applies a reverse voltage between the anode and the cathode of the PQD according to a gray scale value in a re-emissive mode.

Each driving circuit includes an activation transistor and a driver transistor. The activation transistor may be turned on according to a potential of the scan line connected to the circuit and, when turned on, outputs a potential of the data line connected to the circuit. The driver transistor is connected between a reference voltage terminal and a PQD driven by the circuit. When the activation transistor is turned on, a potential applied to the reference voltage terminal is applied to an anode of the PQD according to the potential of the data line. In an emissive mode, when the driver transistor is turned on, a forward voltage is applied between an anode and cathode of the PQD so that the PQD emits light. In a re-emissive mode, when the driver transistor is turned off, no voltage is applied between the anode and cathode of the PQD so that the PQD produces light by photoluminescence.

Using the circuit of the present invention, a PQD can be operated in the emissive mode and re-emissive mode, depending on the operation of corresponding activation and driver transistors of the circuit. In other words, each PQD in a matrix display driven by a corresponding driving circuit can be operated in the emissive mode under conditions of low ambient light and in the re-emissive mode under conditions of high ambient light. Accordingly, satisfactory brightness can be produced under conditions with high ambient light and low current so that the power consumption and fabrication cost of a display can be reduced.

According to a further aspect of the invention, a circuit for driving a photoluminescence quenching device having an anode and a cathode, and defined as a pixel at crossing of a scan line and a data line, includes an activation transistor having a control electrode connected to the scan line and an input electrode connected to the data line, the activation transistor being turned on in response to potential of the scan line, and, when turned on, outputting potential of the data line; and a driver transistor having a control electrode connected to an output electrode of the activation transistor, the driver transistor being connected between a reference voltage terminal of the circuit and the PQD and, when the activation transistor is turned on, applying to the anode of the PQD the potential that is applied to the reference voltage terminal, according to the potential of the data line, wherein in an emissive mode of operation of the PQD, when the driver transistor is turned on, a forward voltage is applied between the anode and the cathode of the PQD so that the PQD emits light, and in a re-emissive mode of operation of the PQD, when the driver transistor is turned off, no voltage is applied between the anode and the cathode of the PQD so that the PQD produces light by photoluminescence.

According to yet another aspect of the invention a matrix display apparatus includes a plurality of scan lines; a plurality of data lines, orthogonal to and crossing the scan lines; a plurality of photoluminescence quenching devices, each PQD having an anode and a cathode, defining a pixel, and being located at a respective crossing of one of the scan lines and one of the data lines; and a plurality of driving circuits, each driving circuit driving a corresponding PQD and applying a forward voltage between the anode and the cathode of the corresponding PQD, according to a gray scale value, in an emissive mode of operation of the corresponding PQD, and applying a reverse voltage between the anode and the cathode of the corresponding PQD, according to the gray scale value, in a re-emissive mode of operation of the corresponding PQD.

Further, in the matrix display apparatus, each of driving circuits includes an activation transistor having a control electrode connected to a respective scan line and an input electrode connected to a respective data line, the activation transistor being turned on in response to potential of the respective scan line, and, when turned on, outputting potential of the respective data line; and a driver transistor having a control electrode connected to an output electrode of the activation transistor, the driver transistor being connected between a reference voltage terminal of the driving circuit and the corresponding PQD and, when the activation transistor is turned on, applying to the anode of the corresponding PQD potential that is applied to the reference voltage terminal in response to the potential of the respective data line.

In the driving circuits, a respective storage capacitor is connected between control electrodes and input electrodes of the respective driver transistors.

According to yet another aspect of the invention, a method is provided for driving a driving circuit for controlling a PQD of a matrix display apparatus. According to the method of the present invention the activation transistor is turned on in response to a potential of the scan line. When the activation transistor is turned on, the driver transistor applies to the anode of the PQD the potential that is applied to the reference voltage terminal, according to the potential of the data line. In an emissive mode of operation of the PQD, when the driver transistor is turned on, a forward voltage according to a gray scale value is applied between the anode and the cathode of the PQD so that the PQD emits light, while in a re-emissive mode of operation of the PQD, when the driver transistor is turned off, a reverse voltage according to a gray scale value is applied between the anode and the cathode of the PQD so that the PQD produces light by photoluminescence.

### BRIEF DESCRIPTION OF THE DRAWINGS

The above and other features and advantages of the present invention will become more apparent by describing in detail a preferred embodiment thereof with reference to the attached drawings in which:
FIG. 1 is a cross-section of a typical photoluminescence quenching device;
FIG. 2A is a diagram of the PQD shown in FIG. 1 operating in an emissive mode;
FIG. 2B is a diagram of the PQD shown in FIG. 1 operating in a re-emissive mode;
FIG. 3 is a block diagram of a driver circuit for driving the PQD shown in FIG. 1 according to an embodiment of the present invention;
FIG. 4 is a block diagram of a 3×3 PQD matrix display panel including driver circuits as shown in FIG. 3;
FIG. 5 is a detailed block diagram of the driver circuit shown in FIG. 3;
FIG. 6 is a diagram of the driver circuit shown in FIG. 5, which includes P-channel thin film polysilicon field effect transistors (FETs);
FIGS. 7 and 8 are detailed block diagrams of a 3×3 PQD matrix display panel including driver circuits as shown in FIG. 5; and
FIG. 9 is a timing chart showing the voltage waveforms of signals in the driver circuit shown in FIG. 6.

### DETAILED DESCRIPTION OF THE INVENTION

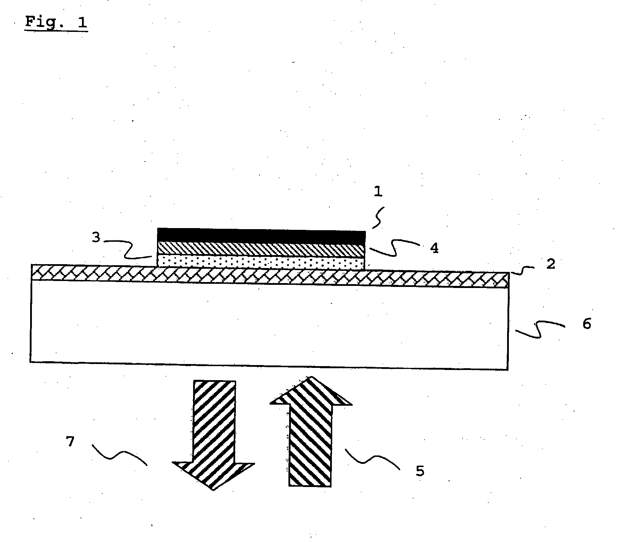

The structure of a typical photoluminescence quenching device will be described with reference to FIG. 1. A light-permeable anode 2 is arranged on a transparent substrate 6. A hole injection layer 3 is disposed on the light-permeable anode 2. An emitter material layer 4 is disposed on the hole injection layer 3. A cathode 1 is located on the emitter material layer 4. When polymer materials are used for the hole injection layer 3 and the emitter material layer 4, the hole injection layer 3 can be formed by dispersing polyethylene dioxy thiophene (PEDOT), polystyrene sulfone acid, and polyaniline using spin-coating, spraying, doctor blade application and spreading, and inkjet printing. The emitter material layer 4 can be formed by spin-coating, spraying, doctor blade application, scrape-depositing, spreading, and inkjet printing of polyphenylene-vinylene and polyfluorene. When low molecular weight materials are used for the active layers, i.e., the hole injection layer 3 and the emitter material layer 4, the active layers 3 and 4 can be formed by vapor deposition using a metal mask. In FIG. 1, reference numeral 5 denotes incident light, and reference numeral 7 denotes outgoing light.

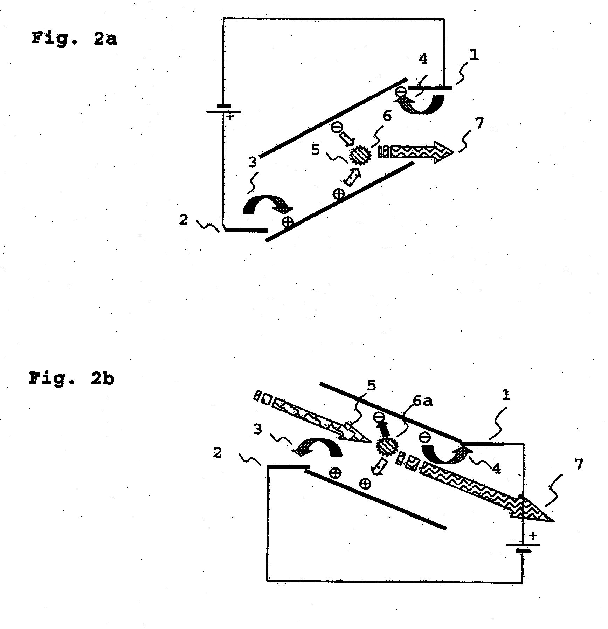

Referring to FIG. 2A illustrating emissive mode operation of a PQD, charge carriers are injected into the PQD and recombine (5a) via an excited state accompanied by emission of light (7a). In FIG. 2A, reference character 6a denotes the excited state that is formed as an intermediate. Holes are injected (3a) via the anode 2, which may be indium tin oxide (ITO) or combinations of ITO with conducting polymers like PEDOT. Electrons are injected (4a) via negative cathode 1, a metal, such as calcium or aluminium. The cathode 1 can include isolating layers of inorganic materials which provide a blocking function so that optimal charge injection occurs. A current source is connected between the anode 2 and the cathode 1 of the PQD. Current flow leads to a light emission by an electro-luminescent material. In this emissive mode, the current source is connected to the PQD in a forward direction.

Referring to FIG. 2B illustrating re-emissive mode operation of a PQD, external light 5b is incident via the emitter material layer 4 shown in FIG. 1 and is transformed into photoluminescence light 7b which is re-emitted. In other words, the display element is operated in a photoluminescence quenching mode. In this photoluminescence quenching mode, the photoluminescence emission of an organic material may be suppressed, i.e., quenched, by a reverse electric field. In an initial stage, the emitter material layer 4 is optically excited by the external light 5b. Excitation states decay during a few nanoseconds when photoluminescence emission occurs. The emitted light has a color that depends on the emitter material.

When a reverse voltage is applied between the anode 2 and the cathode 1 of the PQD, an electric field is generated in the emitter material layer 4. This electric field dissociates the excited state 6a before photoluminescence emission occurs. In this way, the overall number of excited states is reduced, and thus the intensity of photoluminescence light is reduced. Accordingly, the intensity of photoluminescence emission can be controlled by the applied voltage. Without an applied voltage, the intensity of photoluminescence emission is at its maximum. With reference to quantum efficiency, the photoluminescence quenching mode has significant advantages. In each quenched excitation, one pair of charge carriers 3b and 4b are absorbed at the anode 2 and cathode 1, sequentially. Meanwhile, in case of using a standard singlet emitter material, the creation of one excited singlet state in the emissive mode will require at least four charge carrier pairs to be injected from the contacts.

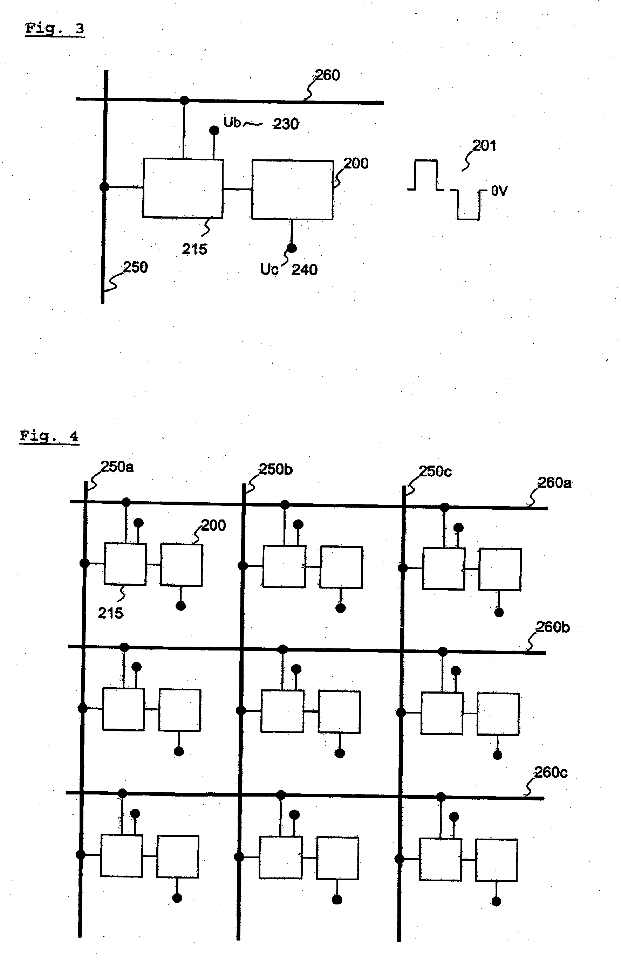

FIG. 3 is a block diagram of a driver circuit according to an embodiment of the present invention for driving the PQD shown in FIG. 1. An activation circuit 215 is connected to a scan line 260, a data line 250, and a reference voltage terminal 230. A PQD 200 is connected between the activation circuit 215 and a cathode voltage terminal 240.

In a line scanning action, by simultaneously applying a scan voltage to the scan line 260 and a data voltage to the data line 250, the activation circuit 215 applies a forward voltage between the anode and the cathode of the PQD 200 for emission mode operation and a reverse voltage between the anode and the cathode of the PQD 200 for photoluminescence quenching operation. For these operations, it is necessary to apply appropriate voltages to the reference and cathode voltage terminals 230 and 240. Reference numeral 201 denotes a voltage applied between the anode and the cathode of the PQD. More particularly, the reference numeral 201 denotes the forward voltage applied during the emission mode operation and the reverse voltage during a reemission, i.e., quenching operation.

When a plurality of the driver circuits are connected to respective crossing points of N scan lines and M data lines, an N×M matrix display panel can be constructed. FIG. 4 shows the driver circuit shown in FIG. 3 applied to a 3×3 PQD matrix display panel. Scan lines 260a, 260b, and 260c are sequentially activated during each scan period in order to reproduce video information using PQDs 200 via activation circuits 215. During each scan period a control voltage is applied to data lines 250a, 250b, and 250c according to the video information. By constant and repetitive scanning, the video information is reproduced as an image on the display panel of the matrix of PQDs.

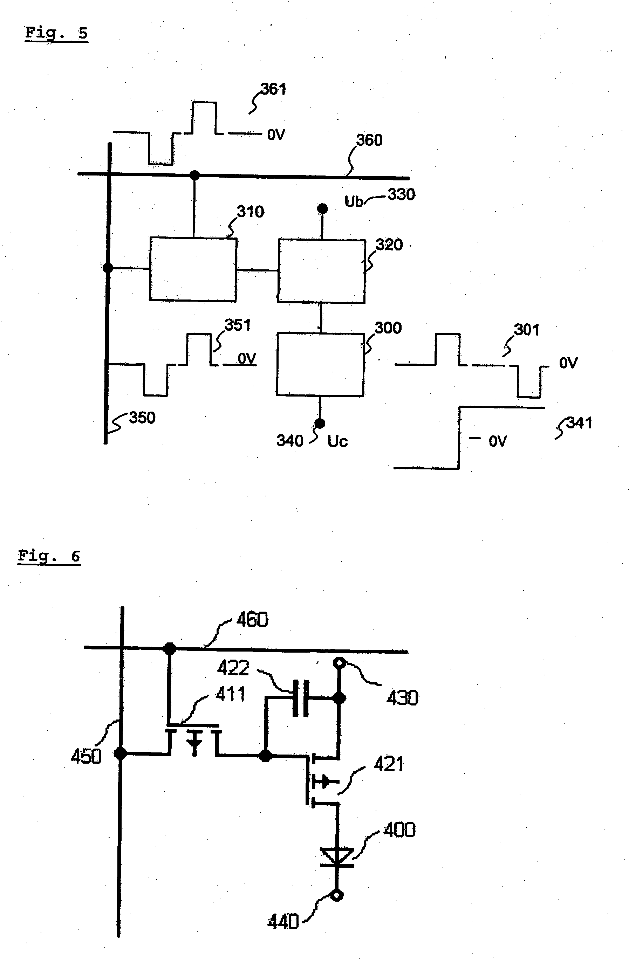

FIG. 5 is a detailed block diagram of the driver circuit shown in FIG. 3. A first circuit 310 is connected to a scan line 360 and a data line 350. A second circuit 320 is connected to the first circuit 310, a PQD 300, and a reference voltage terminal 330. The PQD 300 is connected between the second circuit 320 and a cathode voltage terminal 340. The following description concerns voltages applied to the reference voltage terminal 330 and individual nodes of the driver circuit.

A zero voltage is applied to the reference voltage terminal 330. The cathode voltage terminal 340 has, relative to the anode of the PQD 300, a negative polarity in an emissive mode operation of the PQD 300 and a positive polarity in a re-emissive mode operation of the PQD 300. In FIG. 5, reference numerals 301, 341, 351, and 361 denote voltage signals applied for both the emissive and re-emissive modes. More specifically, reference numeral 301 denotes a voltage waveform applied between the anode and the cathode of the PQD 300. Reference numeral 341 denotes a voltage waveform applied to the cathode voltage terminal 340. Reference numeral 351 denotes a voltage waveform applied to the data line 350. Reference numeral 361 denotes a voltage waveform applied to the scan line 360.

In a line scanning action, when a negative scan voltage is applied to the scan line 360, the voltage applied to the data line 350 is applied to the second circuit 320 via the first circuit 310, when activated. The second circuit 320 applies the voltage Ub that is applied to the reference voltage terminal 330 to the anode of the PQD 300. Since a negative voltage Uc is applied to the cathode voltage terminal 340 of the PQD 300, a forward voltage is applied between the anode and the cathode of the PQD 300. Accordingly, the PQD 300 emits light and corresponds to a bright pixel. If a voltage of zero volts, instead of the negative voltage, is applied to the data line 350, zero volts is applied to the PQD 300, and thus the PQD 300 does not emit light and corresponds to a dark pixel.

Even if the first circuit 310 is deactivated by applying zero volts to the scan line 360, the voltage at the PQD 300 remains constant up to the next line scanning action, regardless of the voltage at the data line 350.

The re-emissive mode presupposes the existence of sufficient ambient light for photoluminescence. In a line scanning action, zero volts is applied to the scan line 360 connected to the first circuit 310, and a positive voltage Uc is applied to the cathode voltage terminal 340 of the PQD 300. Under these conditions, if zero volts is applied to the data line 350, the second circuit 320 applies a reverse voltage between the anode and the cathode of the PQD 300 for photoluminescence quenching. Accordingly, the PQD corresponds to a dark pixel. If a positive voltage, instead of zero volts, is applied to the data line 350, no voltage is applied between the anode and the cathode of the PQD 300, and thus the PQD corresponds to a bright pixel due to photoluminescence.

Even if the first circuit 310 is turned off by applying a positive voltage to the scan line 360, the voltage at the PQD 300 remains constant up to the next line scan action, regardless of the voltage at the data line 350.

FIG. 6 is a diagram of the driver circuit shown in FIG. 5, which includes P-channel thin film polysilicon field effect transistors (FETs). For reasons of simplicity, we refer only to a pixel circuit that is based on P-channel thin film polysilicon FETs. A driver circuit based on N-channel thin film polysilicon FETs or a combination of N-channel and P-channel thin film polysilicon FETs can also be used.

Referring to FIG. 6, the driver circuit for a PQD 400 according to the present invention includes an activation transistor 411 as the first circuit and a driver transistor 421 as part of a second circuit.

The gate of the activation transistor 411 is connected to a scan line 460. The source of the activation transistor 411 is connected to a data line 450. The driver transistor 421 supplies necessary voltages and currents for emissive and re-emissive modes to the PQD 400. The gate of the driver transistor 421 is connected to the drain of the activation transistor 411. The source of the driver transistor 421 is connected to a reference voltage terminal 430, and the drain is connected to the PQD 400. A storage capacitor 422 is connected between the gate and the source of the driver transistor 421. A voltage applied to the reference voltage terminal 430 is referred to as a reference voltage. In an embodiment of the present invention, zero volts is applied as the reference voltage.

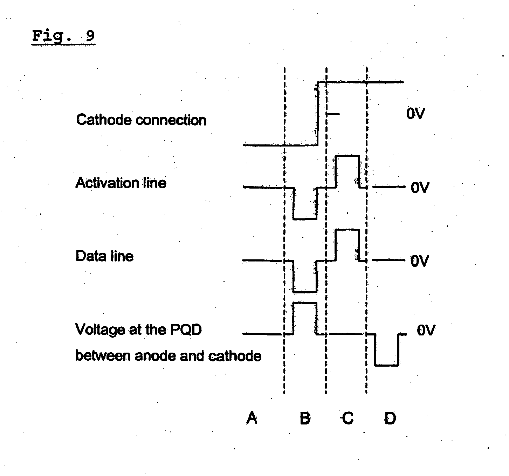

In a line scanning action in an emissive mode (corresponding to time ranges A and B in FIG. 9, described below), upon applying a negative voltage to the scan line 460, the activation transistor 411 is turned on, and thus a negative voltage at the data line 450 is applied to the gate of the driver transistor 421. The driver transistor 421 is turned on, and, thus, the negative voltage is applied to the cathode 440 of the PQD 400, so that a forward voltage is applied between the anode and the cathode of the PQD 400. Accordingly, the PQD emits light and corresponds to a bright pixel. If zero volts is applied to the data line 450, the driver transistor 421 is turned off, and thus no voltage is applied between the anode and the cathode of the PQD 400. Accordingly, the PQD 400 corresponds to a dark pixel.

Even if the activation transistor 411 is turned off by applying zero volts to the scan line 460, the voltage applied to the PQD 400 is continuously and constantly applied to the PQD 400 until the next line scanning action, regardless of the voltage at the data line 450. The storage capacitor 422 maintains constant the voltage applied to the gate and the source of the driver transistor 421, up to the next line scanning action. In the emissive mode, in order to turn on both transistors 411 and 421, the potential of the scan line 460 must be smaller than the sum of the potential of the data line 450 and the threshold voltage of the activation transistor 411, and the potential of the data line 450 must be smaller than the threshold voltage of the driver transistor 421.

Table 1 summarizes the functions of voltages applied to P-channel thin film polysilicon FETs, which have a threshold voltage of -2.5 V, in the emissive mode.

**Table 1**

| Related reference numeral | Item | Value | Unit | Functions |
|---|---|---|---|---|
| 430 | Reference voltage | 0 | V | Reference voltage |
| 440 | Cathode voltage | -12 | V | Cathode voltage |
| 460 | Scan voltage | -15 | V | Activation transistor 411 is turned on, and thus the data voltage is programmed. |
| 460 | Scan voltage | 0 | V | Activation transistor 411 is turned on, and thus the data voltage is not programmed. The data voltage remains stored in the storage capacitor 422. The pixel remains dark or bright depending on the previously programmed data voltage. |
| 450 | Data voltage | -10 | V | If the activation transistor 411 is turned on, the driver transistor 421 is turned on. The PQD 400 emits light in response to a forward voltage. If the activation transistor 411 is turned off, no change occurs. |
| 450 | Data voltage | 0 | V | If the activation transistor 411 is turned on, the driver transistor 421 is turned off. Since no voltage is applied to the PQD 400, emission does not occur. If the activation transistor 411 is turned off, no change occurs. |

A re-emissive mode (corresponding to time ranges C and D in FIG. 9) presupposes the existence of sufficient ambient light for photoluminescence. In a line scanning action, if zero volts is applied to the scan line 460 when a positive voltage is applied to the cathode 440 of the PQD 400, the activation transistor 411 is turned on. If zero volts is applied to the data line 450, the driver transistor 421 is turned on, and thus a reverse voltage for photoluminescence quenching is applied between the anode and the cathode of the PQD 400. Accordingly, the PQD 400 corresponds to a dark pixel. If a positive voltage, instead of zero volts, is applied to the data line 450, no voltage is applied between the anode and the cathode of the PQD 400. Accordingly, photoluminescence occurs, and the PQD 400 corresponds to a bright pixel.

Even if the activation transistor 411 is turned off by applying a positive voltage to the scan line 460, the voltage applied to the PQD 400 is continuously and constantly applied to the PQD 400 until the next line scanning action, regardless of the voltage at the data line 450. The storage capacitor 422 maintains constant the voltage applied to the gate and the source of the driver transistor 421, until the next line scanning action. In the re-emissive mode, in order to turn off the activation transistor 411, the potential of the scan line 460 must be greater than the potential of the data line 450. In order to turn off the driver transistor 421, the potential of the data line 450 must be greater than a difference between the potential of the cathode 440 and the threshold voltage of the driver transistor 421.

Table 2 summarizes the functions of voltages applied to P-channel thin film polysilicon FETs, which have a threshold voltage of -2.5 V, in the re-emissive mode.

**Table 2**

| Related reference numeral | Item | Value | Unit | Functions |
|---|---|---|---|---|
| 430 | Reference voltage | 0 | V | Reference voltage |
| 440 | Cathode voltage | +17 | V | Cathode voltage |
| 460 | Scan voltage | 0 | V | Activation transistor 411 is turned on, and thus the data voltage is programmed. |
| 460 | Scan voltage | +23 | V | Activation transistor 411 is turned on, and thus the data voltage is not programmed. The data voltage remains stored in the storage capacitor 422. The pixel remains dark or bright depending on the previously programmed data voltage. |
| 450 | Data voltage | 0 | V | If the activation transistor 411 is turned on, the driver transistor 421 is turned on. The PQD 400 does not emit light in response to a reverse voltage. If the activation transistor 411 is turned off, no change occurs. |
| 450 | Data voltage | +20 | V | If the activation transistor 411 is turned on, the driver transistor 421 is turned off. Since no voltage is applied to the PQD 400, emission is performed. If the activation transistor 411 is turned off, no change occurs. |

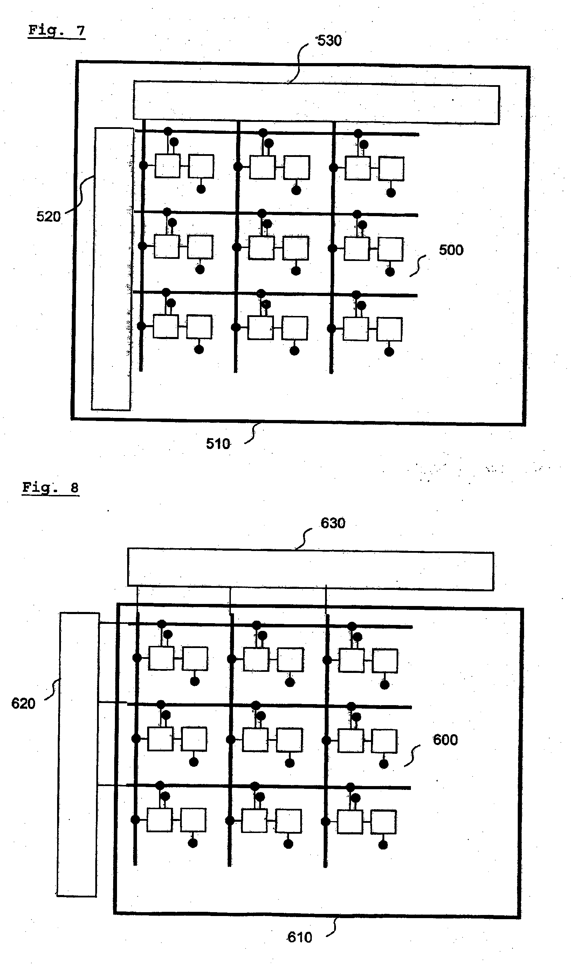

FIGS. 7 and 8 show the driver circuit shown in FIG. 5 applied to a 3x3 PQD matrix display panel. In FIG. 7, a scan driver 520 and a data driver 530, which are used to generate the driving signals, are located within a display panel 510 together with a PQD matrix 500. In FIG. 8, a PQD matrix 600 is located within a display panel 610, and a scan driver 620 and a data driver 630 are located outside the display panel 610.

FIG. 9 shows the voltage waveforms of signals in the driver circuit shown in FIG. 6. In FIG. 9, reference character S_{C} denotes a voltage waveform applied to the cathode 440 of the PQD 400. Reference character S_{S} denotes a voltage waveform applied to the scan line 460. Reference character S_{D} denotes a voltage waveform applied to the data line 450. Reference character S_{P} denotes a voltage waveform applied between the anode and the cathode of the PQD 400. The levels of the voltage waveforms are related to the voltage applied to the reference voltage terminal 430. A voltage of 0 V is applied to the reference voltage terminal 430. In the time ranges A and B, emissive mode operation is possible. In the time ranges C and D, re-emissive mode operation is possible. The brightness of the PQD 400 depends on the applied forward and reverse voltages. In other words, in the emissive mode, a forward voltage is applied between the anode and the cathode of each PQD 400 according to the gray scale value of the PQD 400. In the re-emissive mode, a reverse voltage is applied between the anode and the cathode of each PQD 400 according to the gray scale value of the PQD 400. The absolute value of the forward voltage applied between the anode and the cathode of each PQD 400 in the emissive mode is proportional to the gray scale value of the PQD 400. The absolute value of the reverse voltage applied between the anode and the cathode of each PQD 400 in the re-emissive mode is inversely proportional to the gray scale value of the PQD 400. Accordingly, the gray scale values of the display elements can be controlled by the control voltage, i.e., the data voltage. In other words, a gray scale display can be produced in a display panel according to the invention. Meanwhile, it is also possible that the source and drain of the transistors are interchanged in contrast to the circuit in FIG. 6.

As described above, a driver circuit according to the present invention can operate PQDs in both the emissive and re-emissive modes depending on the operation of an activation transistor and the operation of a driver transistor of the driver circuit. The PQDs can be operated in the emissive mode in low ambient light and in the re-emissive mode under conditions with high ambient light. Accordingly, satisfactory brightness can be obtained under conditions of high ambient light with low current so that the power consumption and fabrication cost of a display incorporating the PQDs and driver circuits can be reduced.

## Claims

1. A method of driving a driving circuit (215) for controlling a PQD (200, 400) of a matrix display apparatus, the matrix display apparatus comprising:
a plurality of scan lines (260);
a plurality of data lines (250), orthogonal to and crossing the scan lines (260);
a plurality of photoluminescence quenching devices (200), each PQD (200) having an anode and a cathode, defining a pixel, and being located at a respective crossing of one of the scan lines (260) and one of the data lines (250); and
a plurality of driving circuits (215), each driving circuit (215) adapted to drive a corresponding PQD (200), and
each driving circuit (215) is adapted to apply a forward voltage between the anode and the cathode of the corresponding PQD (200) in an emissive mode of operation of the corresponding PQD (200), so that the PQD (200) emits light, the forward voltage having an absolute value proportional to a gray scale value, and
each driving circuit (215) is adapted to apply a reverse voltage between the anode and the cathode of the corresponding PQD (200) in a re-emissive mode of operation of the corresponding PQD (200), so that the PQD (200) produces light by photoluminescence, the reverse voltage having an absolute value inversely proportional to the gray scale value,
wherein each of driving circuits comprises:
an activation transistor (411) having a control electrode connected to a respective scan line (260, 460) and an input electrode connected to a respective data line (250, 450), the activation transistor (411) being adapted to be turned on in response to a potential of the respective scan line (260, 460), and, when turned on, being adapted to output a potential according to the respective data line (250, 450); and
a driver transistor (421) having a control electrode connected to an output electrode of the activation transistor (411), the driver transistor (421) being connected between a reference voltage terminal (230, 430) of the driving circuit (215) and the corresponding PQD (200, 400) and, when the activation transistor (411) is turned on, being adapted to apply to the anode of the corresponding PQD (200, 400) the potential that is applied to the reference voltage terminal (230, 430), according to the potential of the respective data line (260, 460), the method comprising the following steps:
simultaneously applying a scan voltage to the scan line (260) and a data voltage to the data line (250); wherein
- the activation transistor (411) is turned on in response to a potential of the scan line (260, 460); and
- the driver transistor (421) applies to the anode of the PQD (200, 400) the potential that is applied to the reference voltage terminal (230, 430), according to the potential of the data line (250, 450);
**characterized by**
- driving the display in an emissive mode of operation of the PQD (200, 400) under conditions of low ambient light, wherein the driver transistor (421) is turned on and a forward voltage is applied between the anode and the cathode of the PQD (200, 400) so that the PQD (200, 400) emits light,
- driving the display in a re-emissive mode of operation of the PQD (200, 400) under conditions of high ambient light, wherein the driver transistor (421) is turned off and a reverse voltage is applied between the anode and the cathode of the PQD (200, 400) so that the PQD (200, 400) produces light by photoluminescence, wherein the intensity of photoluminescence emission can be controlled by the applied voltage,
wherein an absolute value of the forward voltage is proportional to a gray scale value and an absolute value of the reverse voltage is inversely proportional to the gray scale value,
wherein during the operation in the emissive mode and in the re-emissive mode, the gray scale values of the display elements are controlled by the data voltage,
wherein scan lines (260a, 260b, 260c) are sequentially activated during each scan period in order to reproduce video information using PQDs (200) via driving circuits (215), and
wherein during each scan period a control voltage is applied to data lines (250a, 250b, 250c) according to video information, wherein the video information is reproduced as an image on the display panel of the matrix of PQDs (200) by constant and repetitive scanning.

2. The method of claim 1, wherein, in the emissive mode, a negative voltage, with respect to the voltage that is applied to the reference voltage terminal (230, 430), is applied to the cathode of the PQD (200, 400).

3. The method of one of claims 1 and 2, wherein, in the re-emissive mode, a positive voltage, with respect to the voltage that is applied to the reference voltage terminal (230, 430), is applied to the cathode of the PQD (200, 400).

## Patentansprüche

1. Verfahren zur Ansteuerung eines Treiberschaltkreises (215) zur Steuerung eines Photolumineszenzlöschelements (PQD) (200, 400) einer Matrixanzeigevorrichtung, wobei die Matrixanzeigevorrichtung aufweist:
eine Vielzahl von Ansteuerleitungen (260);
eine Vielzahl von Datenleitungen (250), die senkrecht zu den Ansteuerleitungen (260) verlaufen und diese kreuzen;
eine Vielzahl von Photolumineszenzlöschelementen (200), wobei jedes Photolumineszenzlöschelement (200) eine Anode und eine Kathode aufweist, einen Pixel definiert und an einem jeweiligen Kreuzungspunkt einer der Ansteuerleitungen (260) und einer der Datenleitungen (250) positioniert ist; und
eine Vielzahl von Treiberschaltkreisen (215), wobei jeder Treiberschaltkreis (215) zur Ansteuerung eines entsprechenden Photolumineszenzlöschelements (200) geeignet ist, und
wobei jeder Treiberschaltkreis (215) geeignet ist, eine Durchlassspannung zwischen der Anode und der Kathode des entsprechenden Photolumineszenzlöschelements (200) in einem emissiven Betriebsmodus des entsprechenden Photolumineszenzlöschelements (200) anzulegen, so dass das Photolumineszenzlöschelement (200) Licht emittiert, wobei die Durchlassspannung einen absoluten Wert aufweist, der proportional zu einem Graustufenwert ist, und
wobei jeder Treiberschaltkreis (215) geeignet ist, eine Sperrspannung zwischen der Anode und der Kathode des entsprechenden Photolumineszenzlöschelements (200) in einem reemissiven Betriebsmodus des entsprechenden Photolumineszenzlöschelements (200) anzulegen, so dass das Photolumineszenzlöschelement (200) Licht durch Photolumineszenz erzeugt, wobei die Sperrspannung einen absoluten Wert aufweist, der umgekehrt proportional zum Graustufenwert ist,
wobei jeder der Treiberschaltkreise aufweist:
einen Aktivierungstransistor (411), der eine Steuerelektrode, die mit einer jeweiligen Ansteuerleitung (260, 460) verbunden ist, und eine Eingangselektrode aufweist, die mit einer jeweiligen Datenleitung (250, 450) verbunden ist, wobei der Aktivierungstransistor (411) geeignet ist, in Reaktion auf ein Potential der jeweiligen Ansteuerleitung (260, 460) eingeschaltet zu werden, und wobei er, wenn er eingeschaltet ist, geeignet ist, ein Potential gemäß der jeweiligen Datenleitung (250, 450) auszugeben; und
einen Treibertransistor (421), der eine Steuerelektrode aufweist, die mit einer Ausgangselektrode des Aktivierungstransistors (411) verbunden ist, wobei der Treibertransistor (421) zwischen einem Referenzspannungsanschluss (230, 430) des Treiberschaltkreises (215) und dem entsprechenden Photolumineszenzlöschelement (200, 400) geschaltet ist, und wobei er, wenn der Aktivierungstransistor (411) eingeschaltet ist, geeignet ist, gemäß dem Potential der jeweiligen Datenleitung (260, 460) das Potential an die Anode des entsprechenden Photolumineszenzlöschelements (200, 400) anzulegen, das am Referenzspannungsanschluss (230, 430) anliegt, wobei das Verfahren die folgenden Schritte aufweist:
simultanes Anlegen einer Ansteuerspannung an die Ansteuerleitung (260) und einer Datenspannung an die Datenleitung (250); wobei
- der Aktivierungstransistor (411) in Reaktion auf ein Potential der Ansteuerleitung (260, 460) eingeschaltet wird; und
- der Treibertransistor (421) gemäß dem Potential der Datenleitung (250, 450) das Potential an die Anode des Photolumineszenzlöschelements (200, 400) anlegt, das am Referenzspannungsanschluss (230, 430) anliegt;
**gekennzeichnet durch**
- Ansteuern der Anzeige in einem emissiven Betriebsmodus des Photolumineszenzlöschelements (200, 400) unter Bedingungen von geringem Umgebungslicht, wobei der Treibertransistor (421) eingeschaltet wird und eine Durchlassspannung zwischen der Anode und der Kathode des Photolumineszenzlöschelements (200, 400) angelegt wird, so dass das Photolumineszenzlöschelement (200, 400) Licht emittiert,
- Ansteuern der Anzeige in einem reemissiven Betriebsmodus des Photolumineszenzlöschelements (200, 400) unter Bedingungen von starkem Umgebungslicht, wobei der Treibertransistor (421) ausgeschaltet wird und eine Sperrspannung zwischen der Anode und der Kathode des Photolumineszenzlöschelements (200, 400) angelegt wird, so dass das Photolumineszenzlöschelement (200, 400) Licht **durch** Photolumineszenz erzeugt, wobei die Stärke der Photolumineszenzemission **durch** die anliegende Spannung gesteuert werden kann,
wobei ein absoluter Wert der Durchlassspannung proportional zu einem Graustufenwert ist und ein absoluter Wert der Sperrspannung umgekehrt proportional zu dem Graustufenwert ist,
wobei die Graustufenwerte der Anzeigeelemente während des Betriebs im emissiven Modus und im reemissiven Modus **durch** die Datenspannung gesteuert werden,
wobei Ansteuerleitungen (260a, 260b, 260c) während jeder Ansteuerperiode nacheinander aktiviert werden, um (215) Videoinformationen, die Photolumineszenzlöschelemente (200) verwenden, über Treiberschaltkreise wiederzugeben, und
wobei während jeder Ansteuerperiode eine Steuerspannung an Datenleitungen (250a, 250b, 250c) gemäß Videoinformationen anliegt, wobei die Videoinformationen **durch** konstantes und wiederholtes Ansteuern als Bild auf der Anzeigetafel der Matrix der Photolumineszenzlöschelemente (200, 400) wiedergegeben werden.

2. Verfahren nach Anspruch 1, wobei im emissiven Modus eine negative Spannung bezüglich der Spannung, die am Referenzspannungsanschluss (230, 430) anliegt, an der Kathode des Photolumineszenzlöschelements (200, 400) anliegt.

3. Verfahren nach einem der Ansprüche 1 und 2, wobei im reemissiven Modus eine positive Spannung bezüglich der Spannung, die am Referenzspannungsanschluss (230, 430) anliegt, an der Kathode des Photolumineszenzlöschelements (200, 400) anliegt.

## Revendications

1. Procédé d'attaque d'un circuit d'attaque (215) permettant de commander un PQD (200, 400) d'un appareil d'affichage à matrice, l'appareil d'affichage à matrice comprenant :
une pluralité de lignes de balayage (260) ;
une pluralité de lignes de données (250), orthogonales aux lignes de balayage (260) et croisant celles-ci ;
une pluralité de dispositifs de désactivation de photoluminescence (200), chaque PQD (200) ayant une anode et une cathode, définissant un pixel, et étant situé à un croissement respectif de l'une des lignes de balayage (260) et de l'une des lignes de données (250) ; et
une pluralité de circuits d'attaque (215), chaque circuit d'attaque (215) étant adapté pour attaquer un PQD correspondant (200), et
chaque circuit d'attaque (215) est adapté pour appliquer une tension directe entre l'anode et la cathode du PQD correspondant (200) dans un mode d'émission de fonctionnement du PQD correspondant (200), de sorte que le PQD (200) émette de la lumière, la tension directe ayant une valeur absolue proportionnelle à une valeur d'échelle de gris, et
chaque circuit d'attaque (215) est adapté pour appliquer une tension inverse entre l'anode et la cathode du PQD correspondant (200) dans un mode de réémission de fonctionnement du PQD correspondant (200), de sorte que le PQD (200) produise de la lumière par photoluminescence, la tension inverse ayant une valeur absolue inversement proportionnelle à la valeur d'échelle de gris,
dans lequel chacun des circuits d'attaque comprend :
un transistor d'activation (411) ayant une électrode de commande connectée à une ligne de balayage respective (260, 460) et une électrode d'entrée connectée à une ligne de données respective (250, 450), le transistor d'activation (411) étant adapté pour être activé en réponse à un potentiel de la ligne de balayage respective (260, 460), et, lorsqu'il est activé, étant adapté pour délivrer en sortie un potentiel en fonction de la ligne de données respective (250, 450) ; et
un transistor d'attaque (421) ayant une électrode de commande connectée à une électrode de sortie du transistor d'activation (411), le transistor d'attaque (421) étant connecté entre une borne de tension de référence (230, 430) du circuit d'attaque (215) et le PQD correspondant (200, 400) et, lorsque le transistor d'activation (411) est activé, étant adapté pour appliquer à l'anode du PQD correspondant (200, 400) le potentiel qui est appliqué à la borne de tension de référence (230, 430), selon le potentiel de la ligne de données respective (260, 460), le procédé comprenant les étapes suivantes qui consistent :
à appliquer simultanément une tension de balayage à la ligne de balayage (260) et une tension de données à la ligne de données (250) ; où
le transistor d'activation (411) est activé en réponse à un potentiel de la ligne de balayage (260, 460) ; et
le transistor d'attaque (421) applique à l'anode du PQD (200, 400) le potentiel qui est appliqué à la borne de tension de référence (230, 430), en fonction du potentiel de la ligne de données (250, 450) ;
**caractérisé par** le fait
de commander l'affichage dans un mode d'émission de fonctionnement du PQD (200, 400) dans des conditions de lumière ambiante faible, où le transistor d'attaque (421) est activé et une tension directe est appliquée entre l'anode et la cathode du PQD (200, 400) de sorte que le PQD (200, 400) émette de la lumière,
de commander l'affichage dans un mode de réémission de fonctionnement du PQD (200, 400) dans des conditions de lumière ambiante élevée, où le transistor d'attaque (421) est désactivé et une tension inverse est appliquée entre l'anode et la cathode du PQD (200, 400) de sorte que le PQD (200, 400) produise de la lumière par photoluminescence, où l'intensité d'émission de photoluminescence peut être commandée par la tension appliquée,
dans lequel une valeur absolue de la tension directe est proportionnelle à une valeur d'échelle de gris et une valeur absolue de la tension inverse est inversement proportionnelle à la valeur d'échelle de gris,
dans lequel, pendant le fonctionnement en mode d'émission et en mode de réémission, les valeurs d'échelle de gris des éléments d'affichage sont commandées par la tension de données,
dans lequel des lignes de balayage (260a, 260b, 260c) sont séquentiellement activées pendant chaque période de balayage afin de reproduire des informations vidéo en utilisant des PQD (200) par l'intermédiaire de circuits d'attaque (215), et
dans lequel, pendant chaque période de balayage, une tension de commande est appliquée à des lignes de données (250a, 250b, 250c) selon des informations vidéo, où les informations vidéo sont reproduites sous forme d'image sur le panneau d'affichage de la matrice de PQD (200) par balayage constant et répétitif.

2. Procédé de la revendication 1, dans lequel, dans le mode d'émission, une tension négative, par rapport à la tension qui est appliquée à la borne de tension de référence (230, 430), est appliquée à la cathode du PQD (200, 400) .

3. Procédé de l'une des revendications 1 et 2, dans lequel, dans le mode de réémission, une tension positive, par rapport à la tension qui est appliquée à la borne de tension de référence (230, 430), est appliquée à la cathode du PQD (200, 400) .
